# EUROPÄISCHE PATENTANMELDUNG

(11) **EP 2 618 385 A1**
(43) Veröffentlichungstag der Anmeldung: **24.07.2013**
(21) Anmeldenummer: 12000386.8
(22) Anmeldetag: 20.01.2012
(51) Int. Cl.: H01L 31/18

(54) **Halbzeug einer Mehrfachsolarzelle und Verfahren zur Herstellung einer Mehrfachsolarzelle**

(71) Anmelder: AZUR SPACE Solar Power GmbH, 74072 Heilbronn (DE)
(72) Erfinder: Fuhrmann, Daniel, Dr., 74074 Heilbronn (DE)
(74) Vertreter: Koch Müller Patentanwaltsgesellschaft mbH

(57) **Zusammenfassung**

Halbzeug einer Mehrfachsolarzelle mit einem als eine erste Teilsolarzelle ausgebildeten Halbleiterkörper, aufweisend einem ersten Bandabstand, mit einem als einer zweiten Teilsolarzelle ausgebildeten Halbleiterkörper aufweisend einem zweiten Bandabstand, wobei der erste Halbleiterkörper und der zweite Halblelterkörper eine stoffschlüssige Verbindung mit einer Tunneldiode ausbilden und der erste Bandabstand unterschiedlich zu dem zweiten Bandabstand ausgebildet ist und einem als Substratschicht ausgebildeten ersten Trägermaterial, wobei zwischen dem ersten Trägermaterial und der ersten Teilsolarzelle eine Opferschicht ausgebildet ist und das erste Trägermaterial unter Zerstörung der Opferschicht von dem ersten Halbleiterkörper entfernt wird.

## Beschreibung

Die Erfindung betrifft ein Halbzeug einer Mehrfachsolarzelle gemäß dem Oberbegriff des Patentanspruchs 1 und ein Verfahren zur Herstellung einer Solarzelle gemäß dem Oberbegriff des Patentanspruchs 9.

Aus der US 4 774 194 ist ein Verfahren zur Ablösung von III-V-basierten Solarzellschichten von einem Trägersubstrat mittels selektiven chemischen Ätzprozessen bekannt. Des Weiteren sind aus der US 4 883 561 und aus der US 2010/0116784 A1 Verfahren zur Trennung von Halbleiterschichten von deren Trägersubstraten auf Basis von chemischen Ätzprozessen bekannt. Die Trennung von Halbleiterschichten mittels des Verfahrens der Ionenimplantation ist aus der US 5 374 564 bekannt. Weiterhin sind optische Verfahren zur Trennung von Halbleitermateriallen, insbesondere von LED-Schichten auf Basis der Gruppe III Nitride von Substraten mit großer Bandlücke, aus der DE 196 49 594 A1 und der US 6 071 795 bekannt.

Vor diesem Hintergrund besteht die Aufgabe der Erfindung darin, eine Vorrichtung anzugeben, die den Stand der Technik weiterbildet.

Die Aufgabe wird durch ein Halbzeug einer Mehrfachsolarzelle mit den Merkmalen des Patentanspruchs 1 und durch ein Verfahren zur Herstellung einer Solarzelle gemäß dem Oberbegriff des Patentanspruchs 9 gelöst. Vorteilhafte Ausgestaltungen der Erfindung sind Gegenstand von Unteransprüchen.

Gemäß dem ersten Gegenstand der Erfindung wird ein Halbzeug einer Mehrfachsolarzelle bereitgestellt, mit einem als eine erste Teilsolarzelle ausgebildeten Halbleiterkörper, aufweisend einen ersten Bandabstand, mit einem als einer zweiten Teilsolarzelle ausgebildeten Halbleiterkörper aufweisend einen zweiten Bandabstand, wobei der erste Halbleiterkörper und der zweite Halbleiterkörper eine stoffschlüssige Verbindung mit einer Tunneldiode ausbilden und der erste Bandabstand unterschiedlich zu dem zweiten Bandabstand ausgebildet ist und einem als Substratschicht ausgebildeten ersten Trägermaterial, wobei zwischen dem ersten Trägermaterial und der ersten Tellsolarzelle eine Opferschicht ausgebildet ist und das erste Trägermaterial unter Zerstörung der Opferschicht von dem ersten Halbleiterkörper entfernt wird. Es sei angemerkt, dass die beiden Tellsolarzellen stapelförmig angeordnet sind und als Teilsolarzelle ein Halbleiterkörper bezeichnet wird, der als einzelner Halbleiterkörper aus der Energie der einfallenden Photonen eines bestimmten Bereichs des Sonnenspektrums elektrische Energie durch direkte Konversion erzeugt. Die Empfindlichkeitsbereiche der Tellsolarsolarzellen sind so gewählt, dass alle Teilsolarzellen zusammen das Sonnenspektrum möglichst ideal ausnutzen. Mit dem Konzept der gestapelten Mehrfachsolarzelle können heute Konversionseffizienzen bis 40% erreicht werden. Des Weiteren sei angemerkt, dass bei dem Ablösen von dem Substrat vorzugsweise ausschließlich die Opferschicht zerstört wird.

Gemäß dem zweiten Gegenstand der Erfindung wird ein Verfahren zur Herstellung einer Mehrfachsolarzelle bereitgestellt, mit einem als Substratschicht ausgebildeten ersten Trägermaterial, wobei ein als eine erste Teilsolarzelle ausgebildeter Halbleiterkörper, mit einem ersten Bandabstand hergestellt wird, und ein als eine zweite Teilsolarzelle ausgebildeter Halbleiterkörper mit einem zweiten Bandabstand hergestellt wird, wobei zwischen dem ersten Halbleiterkörper und dem zweiten Halbleiterkörper eine stoffschlüssige Verbindung mit einer Tunneldiode ausgebildet wird, und der erste Bandabstand unterschiedlich zu dem zweiten Bandabstand ausgebildet wird, wobei zwischen dem ersten Trägermaterial und der ersten Teilzelle eine Opferschicht hergestellt wird und in einem nachfolgenden Verfahrensschritt das erste Trägermaterial unter Zerstörung der Opferschicht von dem ersten Halbleiterkörper entfernt wird.

Ein Vorteil der Opferschicht auf dem Substrat ist es, dass sich die stapelförmige Mehrfachsolarzelle von dem Substrat auf einfache und kostengünstige Weise ablösen lässt. Mittels des Ablöseprozesses lässt sich die Mehrfachsolarzelle von dem Substrat ohne Beschädigung weder des Substrats noch der Mehrfachsolarzelle trennen. Vorteilhaft ist, nach dem Ablösen eventuelle Reste der Opferschicht auf dem Substrat oder der ersten Teilsolarzelle mittels eines Reinigungsprozess zu entfernen. Des Weiteren ist es vorteilhaft, dass nach dem Ablösen der Substratschicht weitere Teilsolarzellen auf die Mehrfachsolarzelle aufgebracht werden können und hierdurch hocheffiziente Mehrfachsolarzellen bestehend aus einem Stapel von 3, 4 oder mehr Teilsolarzellen hergestellt werden können. Unter hocheffiziente Solarzelle werden Solarzellen verstanden, welche einen Konversionskoeffizient oberhalb 25 % aufweisen.

Es ist bevorzugt, die gestapelte Mehrfachsolarzelle als III-V Solarzelle, d.h. als Solarzelle bestehend aus Verbindungshalbleitern der 3. und 5. Hauptgruppe des Periodensystems, auszuführen. Ferner lässt sich das Substrat für eine Herstellung von Mehrfachsolarzellen wiederverwenden. Indem die Substrate sehr kostenintensiv sind, lassen sich die Herstellungskosten durch die Wiederverwendung der Substrate stark reduzieren. Ein weiterer Vorteil der neuen Abtrenntechnik ist es, dass sich das Ablösen nunmehr sehr schnell und zuverlässig ausführen lässt. Untersuchungen haben gezeigt, dass sich das neue Verfahren bzw. der neuartige Aufbau besonders vorteilhaft auf Mehrfachsolarzellen für Weltraumanwendungen, die eine typische Größe von 8 cm x 4 cm oder größer aufweisen, anwenden lässt. Ferner ist es auch vorteilhaft den neuartigen Ablöseprozess zur Herstellung von Mehrfachsolarzellen, deren Größe unterhalb von 8cm x 4cm vorzugsweise in einem Bereich von 1 mm² bis 400 mm², liegt, anzuwenden. Derartige Mehrfachsolarzellen mit einer geringen Größe lassen sich bevorzugt in terrestrischen Konzentratorsystemen verwenden.

Besonders vorteilhaft lässt sich die Opferschicht derart ausführen, dass sich die Opferschicht unter Absorption elektromagnetischer Energie lokal erhitzen lässt. Mittels der so auftretenden thermisch bedingten Zersetzung der Opferschicht lässt sich das Substrat leicht von dem Solarzellenstapel trennen. Hierdurch werden der Durchsatz und die Ausbeute in der Produktion erhöht und die Herstellungskosten gesenkt.

Zur thermisch induzierten Zersetzung der Opferschicht aufgrund der Absorption elektromagnetischer Strahlung ist es bevorzugt, dass die Opferschicht einen Bandabstand mit einer Energie geringer als 1,5 eV, höchst vorzugsweise kleiner als 1,2 eV, aufweist. Hierdurch ist die Opferschicht nicht transparent für sichtbares Llcht und besitzt eine Absorptionsbande im Infraroten Spektralbereich. Idealerweise, aber nicht notwendigerweise, besitzt die Opferschicht die kleinste Bandlückenenergie aller Schichten der gestapelten Mehrfachsolarzelle. Sofern die anderen Schichten der gestapelten Mehrfachsolarzelle transparent für die eingestrahlte elektromagnetische Strahlung ausgebildet sind, wird hierdurch gewährleistet, dass die eingestrahlte elektromagnetische Energie nur in der Opferschicht absorbiert wird. Vorteilhaft ist es, die Bandlückenenergie der Opferschicht und die Energie der einfallenden elektromagnetischen Strahlung aufeinander abzustimmen. Untersuchungen haben gezeigt, dass es vorteilhaft ist, die Absorptionsbande der Opferschicht auf die Wellenlänge einer infraroten Lasereinrichtung, mit einem gepulsten Laser mit einer Energie von etwa 1,16 eV beispielsweise ein Nd-YAG Laser mit einer Wellenlänge von 1064 nm abzustimmen. Hierzu wird die Bandlückenenergie der Opferschicht auf einen Wert von ≤ 1,15 eV eingestellt.

Untersuchungen haben gezeigt, dass sich je nach Art des Substrates unterschiedliche Materialien für die Opferschicht eignen. Besonders vorteilhaft lässt sich, ausgehend von einem GaAs-Substrat, einem InP-Substrat oder einem Ge-Substrat, die Opferschicht aus InAs, GaAs, InSb, GaSb, InP beziehungsweise deren ternären und quaternären Mischhalbleitern ausbilden. Aufgrund der niedrigen Bandlücke von Ge eignet sich für eine Mehrfachsolarzelle auf einem GaAs- oder einem InP-Substrat insbesondere eine epitaxierte Ge-Opfersschicht. Vorteilhaft ist es, die Opferschicht in einer Dicke zwischen 10nm und 200nm auszubilden.

Gemäß einer Weiterbildung weist die Opferschicht eine zu der Gitterkonstante der ersten Teilsolarzelle unterschiedliche Gitterkonstante auf. Untersuchungen haben gezeigt, dass es vorteilhaft ist die Opferschicht gitterfehlangepasst auf dem Substrat abzuscheiden.

In einer alternativen Ausführungsform ist die Opferschicht zu der ersten Teilsolarzelle gitterangepasst. Hierbei wird bei der Herstellung der Opferschicht die Gitterkonstante im Wesentlichen gleich mit der ersten Teilsolarzelle gewählt.

Untersuchungen haben gezeigt, dass es gemäß einer Weiterbildung besonders vorteilhaft ist, wenn zwischen der Opferschicht und der ersten Tellsolarzelle eine Pufferschicht ausgebildet ist und die Pufferschicht eine stoffschlüssige Verbindung mit der ersten Tellsolarzelle aufweist. Insbesondere bei dem Ablösen wirkt die Pufferschicht als zusätzliche Schutzschicht und unterdrückt eine Beschädigung des ersten Halbleiterkörpers. Untersuchungen haben gezeigt, dass es vorteilhaft ist, die Pufferschicht gitterangepasst, d. h. die Gitterkonstante der Pufferschicht vergleichbar mit der Gitterkonstante der ersten Teilsolarzelle zu wählen. Insbesondere ist es vorteilhaft die Dicke der Pufferschicht zwischen 100 nm und 2 µm zu wählen, höchst vorzugsweise wird die Dicke der Pufferschicht mit 500nm gewählt.

Gemäß einer anderen Weiterbildung ist die Pufferschicht als Bragg-Spiegel ausgebildet. Hierdurch wird bewirkt, dass Licht, welches nicht in dem ersten Halbleiterkörper absorbiert wird, wieder in den ersten Halbleiterkörper zurückreflektiert wird. Hierdurch lässt sich der Wirkungsgrad der Mehrfachsolarzelle erhöhen.

Gemäß einer Ausführungsform ist auf der zweiten Teilsolarzelle eine mit der zweiten Teilsolarzelle stoffschlüssig verbundene Tragschicht angeordnet. Untersuchungen haben gezeigt, dass nach dem Ablösen des Substrats die Tragschicht die Solarzelle mechanisch stabilisiert, insbesondere wenn nach dem Ablösen auf die erste Teilsolarzelle wenigstens eine weitere Teilsolarzelle zur Ausbildung einer Mehrfachsolarzelle bestehend aus 3, 4 oder mehr Teilsolarzellen aufgebracht wird.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:

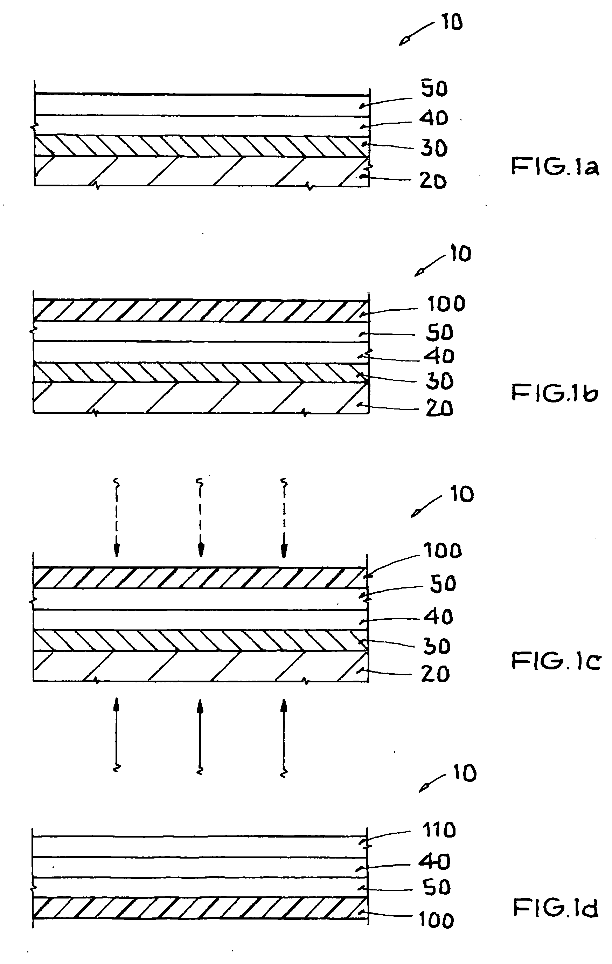

- Figur 1a - 1d: einen Querschnitt auf unterschiedliche Ausführungsformen und Herstellungsschritte von einem Halbzeug einer Mehrfachsolarzelle.

Die Abbildung der Figur 1a zeigt einen schematischen Querschnitt eines Halbzeugs mit einer stapelförmigen Anordnung einer Mehrfachsolarzelle 10, aufweisend eine Substratschicht 20, eine Opferschicht 30, einen ersten Halbleiterkörper 40 und einen mit dem ersten Halbleiterkörper 40 stoffschlüssig verbundenen zweiten Halbleiterkörper 50. Zwischen dem ersten Halbleiterkörper 40 und dem zweiten Halbleiterkörper 50 ist eine Tunneldiode ausgebildet. Die Opferschicht ist vorzugsweise mit dem aufliegenden ersten Halbleiterkörper 40 verbunden. Vorzugsweise ist die Mehrfachsolarzelle als eine III-V Solarzelle, insbesondere unter Verwendung von InGaAs und InGaP, ausgebildet. Des Weiteren ist der erste Halbleiterkörper 40 als erste Teilsolarzelle und der zweite Halbleiterkörper 50 als zweite Teilsolarzelle ausgebildet, wobei die erste Teilsolarzelle einen ersten Bandabstand und die zweite Teilsolarzelle einen zweiten von dem ersten Bandabstand unterschiedlichen Bandabstand aufweist. Des Weiteren weist die Opferschicht einen dritten Bandabstand auf, wobei der dritte Bandabstand kleiner gewählt ist, als der erste Bandabstand und der zweite Bandabstand. Außerdem besteht die Substratschicht aus einem Trägermaterial mit einem vierten Bandabstand, wobei der vierte Bandabstand vorzugsweise kleiner als 1,6 eV und vorzugsweise größer als der dritte Bandabstand ist.

In der Abbildung der Figur 1b ist eine zweite Ausführungsform eines Halbzeugs dargestellt. Im Folgenden werden nur die Unterschiede zur Ausführungsform dargestellt in der Abbildung der Figur 1a erläutert. Auf dem zweiten Halbleiterkörper 50 ist eine Tragschicht 100 ausgebildet. Die Tragschicht lässt sich besonders vorteilhaft auch als Kunststofffolie ausbilden und dient zur mechanischen Stabilisierung des Stapels aus erstem und zweitem Halbleiterkörper 40 und 50 nach der Ablösung.

In der Abbildung der Figur 1c ist ein weiterbildender Prozessschritt des Halbzeugs von der Figur 1b dargestellt. Im Folgenden werden nur die Unterschiede zu Ausführungsformen dargestellt In einer der vorangegangen Figur

ren erläutert. Die Opferschicht 30 wird mittels Infrarotstrahlung, vorzugsweise mittels eines Infrarotlasers erhitzt und zersetzt. Hierbei wird die Wellenlänge der Strahlung an das Absorptionsvermögen der Opferschicht 30 angepasst. Untersuchungen haben gezeigt, dass die Einstrahlung des Lichtes sowohl durch die Vorderseite der Mehrfachsolarzelle, d.h. durch den Stapel aus dem erstem und dem zweiten Halbleiterkörper 40 und 50 hindurch, oder alternativ durch die Substratschicht 20 erfolgt. Bei Bestrahlung durch die Vorderseite ist es in einer Ausführungsform vorteilhaft, wie in Abbildung der Figur 1c dargestellt, die Tragschicht 100 bereits vor der Bestrahlung aufzubringen, sofern die Tragschicht 100 transparent für die Wellenlänge des infraroten Lasers ist. Gemäß einer alternativen Ausführungsform ist es vorteilhaft, die Tragschicht 100 erst nach der Bestrahlung mit Infrarotlicht aufzubringen. Hierbei erfolgt die Bestrahlung des Halbzeugs gemäß der in der Figur 1a dargestellten Ausführungsform, durch die Vorderseite und oder durch die Rückseite. Die nach der Bestrahlung aufgebrachte Tragschicht lässt sich anschließend insbesondere für das Abheben der Mehrfachsolarzelle vom Substrat 20 verwenden.

Gemäß einer Weiterbildung ist es besonders vorteilhaft, die Opferschicht 30 gleichzeitig durch die Vorderseite, d.h. durch die Halbleiterkörper 40 und 50 mit oder ohne Tragschicht 100, und durch die Substratschicht 20 zu bestrahlen. Durch die Einstrahlung mit Licht wird die Opferschicht 30 stark erwärmt. Hierbei wird unter Zerstörung der Opferschicht 30 die Mehrfachsolarzelle von der Substratschicht 20 gelöst.

In der Abbildung der Figur 1d ist ein weiterbildender Prozessschritt des Halbzeugs von der Figur 1c dargestellt. Im Folgenden werden nur die Unter-schiede zu Ausführungsformen dargestellt in einer der vorangegangen Figuren erläutert. Nach dem vollständigen Entfernen der Opferschicht 30 wird die Mehrfachsolarzelle umgedreht und auf dem ersten Halbleiterkörper 40 wird ein dritter Halbleiterkörper 110 ausgebildet. Es sei angemerkt, dass der dritte Halbleiterkörper 110 ebenfalls als III-V Verbindung ausgebildet ist.

## Patentansprüche

1. Halbzeug einer Mehrfachsolarzelle (10) mit,
- einem als eine erste Teilsolarzelle ausgebildeten Halbleiterkörper (40), mit einem ersten Bandabstand,
- einem als einer zweiten Teilsolarzelle ausgebildeten Halbleiterkörper (50) mit einem zweiten Bandabstand, wobei der erste Halbleiterkörper (40) und der zweite Halbleiterkörper (50) eine stoffschlüssige Verbindung mit einer Tunneldiode ausbilden, und
der erste Bandabstand unterschiedlich zu dem zweiten Bandabstand ausgebildet ist,
- einem als Substratschicht (20) ausgebildeten ersten Trägermaterial,
**dadurch gekennzeichnet, dass**
zwischen dem ersten Trägermaterial und der ersten Teilsolarzelle eine Opferschicht (30) ausgebildet ist und das erste Trägermaterial unter Zerstörung der Opferschicht von dem ersten Halbleiterkörper entfernt wird.

2. Halbzeug nach Anspruch 1, **dadurch gekennzeichnet, dass** die Opferschicht (30) eine zu der Gitterkonstante der ersten Teilsolarzelle unterschiedliche Gitterkonstante aufweist.

3. Halbzeug nach Anspruch 1, **dadurch gekennzeichnet, dass** die Opferschicht (30) gitterangepasst zu der ersten Teilsolarzelle ist.

4. Halbzeug nach einem der vorstehenden Ansprüche, **dadurch gekennzeichnet, dass** die Substratschicht (20) eine Bandlücke mit einer Energie kleiner als 1.5 eV aufweist.

5. Halbzeug nach einem der vorstehenden Ansprüche, **dadurch gekennzeichnet, dass** die Opferschicht (30) einen dritten Bandabstand unterhalb von 1,2 eV aufweist.

6. Halbzeug nach Anspruch 1, **dadurch gekennzeichnet, dass** zwischen der Opferschicht (30) und der ersten Teilsolarzelle eine Pufferschicht ausgebildet ist und die Pufferschicht eine stoffschlüssige Verbindung zu der ersten Teilsolarzelle aufweist.

7. Halbzeug nach Anspruch 6, **dadurch gekennzeichnet, dass** die Pufferschicht als Bragg-Spiegel ausgebildet ist.

8. Halbzeug nach einem der vorstehenden Ansprüche, **dadurch gekennzeichnet, dass** auf der zweiten Tellsolarzelle eine mit der zweiten Teilsolarzelle stoffschlüssig verbundene Tragschicht (100) angeordnet ist.

9. Verfahren zur Herstellung einer Mehrfachsolarzelle (10), mit
- einem als Substratschicht (20) ausgebildeten ersten Trägermaterial, wobei
- ein als eine erste Teilsolarzelle ausgebildeter Halbleiterkörper (40), mit einem ersten Bandabstand hergestellt wird,
- ein als eine zweite Teilsolarzelle ausgebildeter Halbleiterkörper (50) mit einem zweiten Bandabstand hergestellt wird, wobei zwischen dem ersten Halbleiterkörper (40) und dem zweiten Halbleiterkörper (50) eine stoffschlüssige Verbindung mit einer Tunneldiode ausgebildet wird, und
der erste Bandabstand unterschiedlich zu dem zweiten Bandabstand ausgebildet wird,
**dadurch gekennzeichnet, dass**
zwischen dem ersten Trägermaterial und der ersten Teilzelle eine Opferschicht (30) hergestellt wird und in einem nachfolgenden Verfahrensschritt das erste Trägermaterial unter Zerstörung der Opferschicht (30) von dem ersten Halbleiterkörper (40) entfernt wird.

10. Verfahren nach Anspruch 9, **dadurch gekennzeichnet, dass** zwischen der Opferschicht (30) und der ersten Teilsolarzelle eine stoffschlüssig mit der ersten Teilsolarzelle verbundene Pufferschicht hergestellt wird.

11. Verfahren nach Anspruch 10, **dadurch gekennzeichnet, dass** die Pufferschicht als Bragg-Spiegel ausgebildet wird.

12. Verfahren nach Anspruch 10 oder Anspruch 11, **dadurch gekennzeichnet, dass** auf der zweiten Teilsolarzelle eine mit der zweiten Tellsolarzelle stoffschlüssig verbundene Tragschicht (100) angeordnet wird.

13. Verfahren nach einem der Ansprüche 9 bis 12, **dadurch gekennzeichnet, dass** die Opferschicht (30) mittels der Absorption einer elektromagnetischen Welle erhitzt und zersetzt wird und die erste Teilsolarzelle und die zweite Teilsolarzelle gemeinsam von der Opferschicht (30) abgelöst werden.

14. Verfahren nach einem der Ansprüche 9 bis 13, **dadurch gekennzeichnet, dass** auf der ersten Teilsolarzelle oder der zweiten Teilsolarzelle eine weitere Einfachsolarzelle oder eine weitere Mehrfachsolarzelle ausgebildet wird und die weitere Einfachsolarzelle oder die weitere Mehrfachsolarzelle einen zur ersten Teilsolarzelle und zur zweiten Teilsolarzelle unterschiedlichen Bandabstand aufweist.
